# EUROPÄISCHE PATENTSCHRIFT

(11) **EP 3 745 596 B1**
(45) Veröffentlichungstag und Bekanntmachung des Hinweises auf die Patenterteilung: **30.08.2023**
(21) Anmeldenummer: 20176448.7
(22) Anmeldetag: 26.05.2020
(51) Int. Cl.: H03K 19/007, G05B 9/03

(54) **DIGITALE EINGANGSSCHALTUNG ZUM EMPFANGEN DIGITALER EINGANGSSIGNALE ZUMINDEST EINES SIGNALGEBERS**
DIGITAL INPUT SWITCHING FOR RECEIVING DIGITAL INPUT SIGNALS OF AT LEAST ONE SIGNAL PROVIDER
CIRCUIT D'ENTRÉE NUMÉRIQUE PERMETTANT DE RECEVOIR DES SIGNAUX D'ENTRÉE NUMÉRIQUE D'AU MOINS UN ÉMETTEUR DE SIGNAUX

(30) Priorität: 29.05.2019 DE 102019114460
(43) Veröffentlichungstag der Anmeldung: 02.12.2020
(73) Patentinhaber: Pilz GmbH & Co. KG, 73760 Ostfildern (DE)
(72) Erfinder: Harrer, Bernd, 73760 Ostfildern (DE)
(74) Vertreter: Schäperklaus, Jochen

(56) Entgegenhaltungen:
- WO-A1-01/48570
- DE-A1- 19 510 332
- DE-A1-102013 106 739

## Beschreibung

Die vorliegende Erfindung betrifft eine digitale Eingangsschaltung zum Empfangen digitaler Eingangssignale zumindest eines Signalgebers, umfassend
- eine erste Teilschaltung mit einem ersten digitalen Eingang, über den der ersten Teilschaltung ein erstes digitales Eingangssignal zuführbar ist, und mit einem ersten Schwellwertelement, mittels dessen ein Zustand der ersten Teilschaltung bestimmbar ist, wobei die erste Teilschaltung einen ersten Zustand einnimmt, wenn das erste digitale Eingangssignal einen unteren Schwellwert erreicht oder unterschreitet, und wobei die erste Teilschaltung einen zweiten Zustand einnimmt, wenn das erste digitale Eingangssignal einen oberen Schwellwert erreicht oder überschreitet, sowie
- zumindest eine zweite Teilschaltung mit einem zweiten digitalen Eingang, über den der zweiten Teilschaltung ein zweites digitales Eingangssignal zuführbar ist, und mit einem zweiten Schwellwertelement, mittels dessen ein Zustand der zweiten Teilschaltung bestimmbar ist, wobei die zweite Teilschaltung einen ersten Zustand einnimmt, wenn das zweite digitale Eingangssignal einen unteren Schwellwert erreicht oder unterschreitet, und wobei die zweite Teilschaltung einen zweiten Zustand einnimmt, wenn das zweite digitale Eingangssignal einen oberen Schwellwert erreicht oder überschreitet.

Eine digitale Eingangsschaltung der eingangs genannten Art kann zum Beispiel in einer Schaltvorrichtung oder in einer Sicherheitsschaltvorrichtung, die für sicherheitsgerichtete Anwendungen, insbesondere in automatisiert arbeitenden technischen Anlagen, vorgesehen ist, eingesetzt werden. Eine derartige digitale Eingangsschaltung weist zumindest zwei digitale Eingänge auf, über die digitale Eingangssignale zumindest eines Signalgebers empfangen werden können. Diese digitalen Eingangssignale stammen zum Beispiel von Sensoreinrichtungen oder Meldegeräten, wie zum Beispiel Not-Aus-Tastern, Not-Halt-Tastern, Schutztüren oder Schaltmatten, die Signalgeber im Sinne der vorliegenden Erfindung sein können.

Digitale Eingangssignale, die von der digitalen Eingangsschaltung empfangen werden, sind binäre Signale und zeichnen sich durch zwei definierte Zustände aus, die beispielsweise durch zwei statische Potentiale definiert sein können. Diese binären Zustände sind durch verschiedene Spannungszustände gekennzeichnet, wobei ein erster Zustand dann eingenommen wird, wenn ein definierter Spannungsschwellwert erreicht oder unterschritten wird. Dabei handelt es sich um einen so genannten Low-Pegel-Zustand. Ein zweiter Zustand wird dann eingenommen, wenn ein definierter Spannungsschwellwert erreicht oder überschritten wird. Dabei handelt es sich um einen so genannten High-Pegel-Zustand.

Digitale Eingangsschaltungen zum Empfangen digitaler Eingangssignale zumindest eines Signalgebers sind aus dem Stand der Technik in ganz unterschiedlichen Ausführungsformen bekannt. Bei stromziehenden digitalen Eingangsschaltungen, die typischerweise mit einer Betriebsspannung von 24 V (DC) betrieben werden, wird gemäß der Norm EN 61131-2:2007 zwischen drei verschiedenen Typen (Typ 1, Typ 2 und Typ 3) unterschieden. Diese drei Typen digitaler Eingangsschaltungen unterscheiden sich insbesondere in ihren High-Pegeln, ihren Low-Pegeln und in ihren Stromaufnahmen voneinander.

Digitale Eingangsschaltungen des Typs 1 müssen spätestens bei einer Eingangsspannung von 15 V zwingend einen High-Pegel erkennen. In der Praxis wird dieser High-Pegel daher bereits bei einer Eingangsspannung < 15 V erfasst. Digitale Eingangsschaltungen des Typs 1 müssen ferner in einem gesamten Eingangsspannungsbereich von 15 V bis 30 V einen High-Pegel erkennen. Die Stromaufnahme ist im High-Pegel-Bereich ≥ 2 mA und kann bis zu 15 mA betragen. Digitale Eingangsschaltungen des Typs 1 (wie auch der weiter unten genannten Typen 2 und 3) müssen ferner dazu in der Lage sein, in einem gesamten Bereich von -3 V bis 5 V einen Low-Pegel zu erkennen. In der Praxis wird ein Low-Pegel daher bereits bei Eingangsspannungen > 5 V erfasst. Im Bereich von -3 V bis 5 V darf der Eingangsstrom zwischen 0 mA und 15 mA liegen. Eine Stromgrenze von 0,5 mA ist dann relevant, wenn die Eingangsspannung zwischen 5 V und 15 V liegt. In diesem Bereich muss der Eingang ebenfalls einen Low-Pegel erkennen, sofern der Eingangsstrom ≤ 0,5mA beträgt. Derartige digitale Eingangsschaltungen des Typs 1 werden insbesondere für elektromechanische Schaltvorrichtungen, wie zum Beispiel Drucktaster oder Relaiskontakte, oder auch für 3-Leiter-Sensoreinrichtungen verwendet. Ein typisches Anwendungsbeispiel für digitale Eingangsschaltungen des Typs 1 sind Not-Aus-Schaltvorrichtungen.

Digitale Eingangsschaltungen des Typs 2 eignen sich zum Beispiel für 2-Leiter-Sensoreinrichtungen und für Halbleitersensoren, die für ihren Betrieb einen relativ hohen Ruhestrom erfordern. Die Stromaufnahme im High-Pegel-Bereich, der zwischen 11 V und 30 V liegt, ist typischerweise ≥ 6 mA und kann bis zu 30 mA betragen.

Digitale Eingangsschaltungen des Typs 3 zeichnen sich gerade bei hohen elektrischen Spannungen durch eine im Vergleich zu digitalen Eingangsschaltungen des Typs 2 geringere Leistungsaufnahme und Abwärme aus, so dass eine größere Anzahl digitaler Eingangsschaltungen und somit eine größere Anzahl physischer digitaler Eingänge zu einem digitalen Eingangsmodul zusammengefasst werden können als bei digitalen Eingangsschaltungen des Typs 2. Digitale Eingangsschaltungen des Typs 3 müssen im Eingangsspannungsbereich zwischen 11 V und 30 V einen High-Pegel erkennen. Die Stromaufnahme ist im High-Pegel-Bereich, der zwischen 11 V und 30 V liegt, typischerweise ≥ 2 mA und kann bis zu 15 mA betragen. Im Eingangsspannungsbereich zwischen -3 V und 5 V müssen digitale Eingangsschaltungen des Typs 3 einen Low-Pegel bei einer zulässigen Stromaufnahme zwischen 0 mA und 15 mA erkennen. Zusätzlich muss ein Low-Pegel erkannt werden, wenn die Eingangsspannung zwischen 5 V und 11 V liegt und der Eingangsstrom ≤ 1,5mA beträgt.

In zahlreichen sicherheitsgerichteten Anwendungen werden digitale Eingangsschaltungen mit digitalen Eingängen verwendet, wobei die Eingangsschaltungen zumindest eine Testeinrichtung umfassen, mit welcher zyklisch überprüft werden kann, ob die den digitalen Eingängen zugeordneten Teilschaltungen noch dazu in der Lage sind, Eingangssignale mit Low-Pegeln zu erkennen, die einem sicheren Zustand entsprechen. Eine derartige digitale Eingangsschaltung ist zum Beispiel aus der DE 10 2013 106 739 A1 bekannt.

Grundsätzlich wäre es wünschenswert, wenn eine digitale Eingangsschaltung, die eine Testeinrichtung der vorstehend genannten Art aufweist, zusätzlich mit einer Stromerhöhungseinrichtung zur kurzzeitigen Erhöhung des Eingangsstroms an den digitalen Eingängen ausgestattet werden könnte, ohne dass sich das Sicherheitsniveau dadurch verringert. Dieses Problem der Verringerung des Sicherheitsniveaus tritt insbesondere dann in Erscheinung, wenn mehrere sichere digitale Eingänge in einem Modul kostengünstig realisiert werden sollen.

Die Vorteile einer kurzzeitigen Eingangsstromerhöhung, wie zum Beispiel eine Reduktion von Störungen, insbesondere bei offenen Leitungen an den digitalen Eingängen, werden ausführlich in der DE 10 2013 101 932 A1 beschrieben. Aus dem vorstehend genannten Dokument ist es bekannt, möglichen Störungen am Eingang aktiv entgegenzuwirken, indem der Eingangsstrom zyklisch erhöht wird. Die Stromerhöhung findet somit nicht kontinuierlich, sondern nur zu definierten Zeitpunkten statt. Eine entsprechende Stromerhöhungseinrichtung gewährleistet in ihrem aktivierten Zustand ein sicheres und schnelles Auswerten der digitalen Eingänge. Die Stromerhöhungseinrichtung wird vorzugweise aktiviert, wenn mit Fehlern beim Auswerten der digitalen Eingänge, die beispielsweise durch ein Übersprechen der Eingänge hervorgerufen werden, zu rechnen ist. Durch den erhöhten Stromfluss an den digitalen Eingängen kann sich dort ein binärer Zustand in Form eines definierten Spannungspegels schneller einstellen. Insbesondere kann der digitale AUS-Zustand, bei dem für gewöhnlich das Nullpotential (d.h. ein Low-Pegel-Signal) erwartet wird, schneller und vor allem sicherer erkannt werden.

Eine mögliche Lösung für die Realisierung einer digitalen Eingangsschaltung mit mindestens zwei sicheren digitalen Eingängen in einem Modul, die sowohl eine Testfunktion als auch eine Stromerhöhungsfunktion aufweist, könnte sich durch eine Kombination einer Testeinrichtung, wie sie in der DE 10 2013 106 739 A1 beschrieben ist, mit einer Stromerhöhungseinrichtung, wie sie in der DE 10 2013 101 932 A1 offenbart ist, ergeben. Wie nachfolgend erläutert werden wird, ist diese Kombination allerdings mit ganz erheblichen praktischen Nachteilen verbunden.

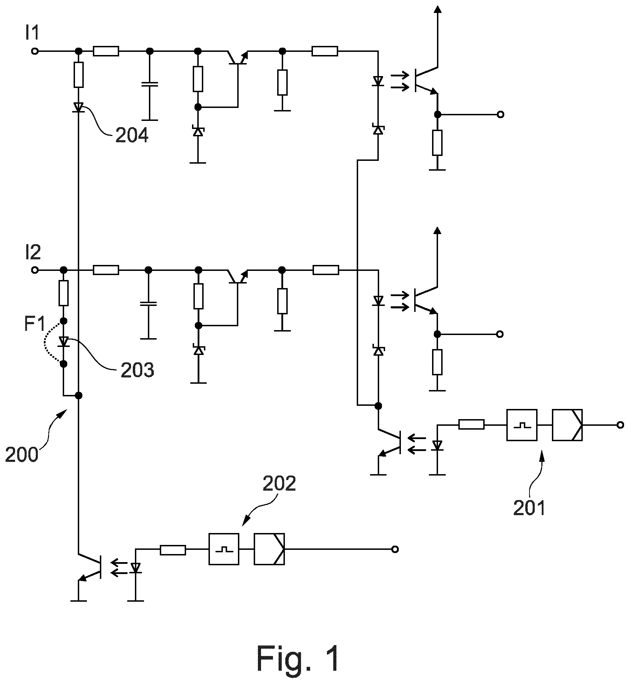

In Fig. 1 ist eine derartige digitale Eingangsschaltung 200 mit zwei digitalen Eingängen I1, I2, einer Testeinrichtung 201 und einer Stromerhöhungseinrichtung 202 dargestellt. Nachfolgend sollen einige wesentliche Aspekt dieser digitalen Eingangsschaltung 200 erläutert werden, wobei allerdings auf Einzelheiten des Schaltungsaufbaus nicht im Detail eingegangen werden soll.

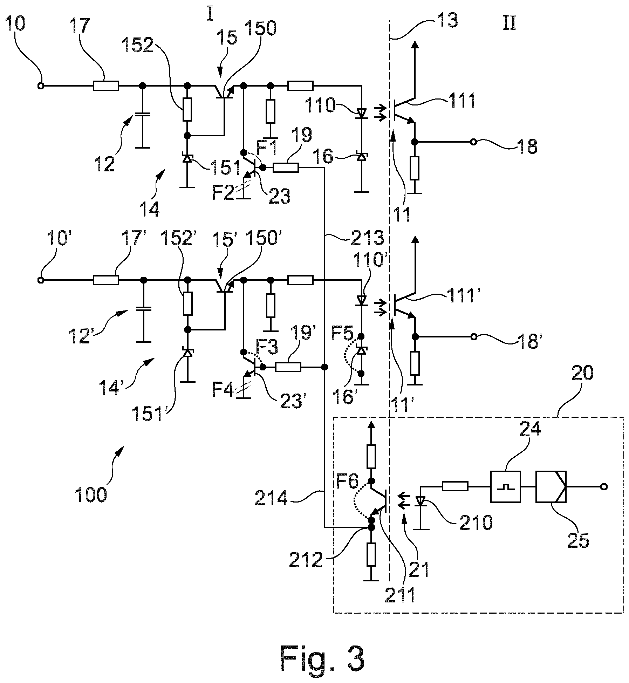

Zur Realisierung der in Fig. 1 gezeigten digitalen Eingangsschaltung 200 wurde für die Testeinrichtung 201 das Ausführungsbeispiel gemäß Fig. 3 der DE 10 2013 106 739 A1 und für die Stromerhöhungseinrichtung 202 das Ausführungsbeispiel gemäß Fig. 7 der DE 10 2013 101 932 A1 verwendet. Der entscheidende Nachteil dieser Realisierung besteht darin, dass bereits ein einzelner Bauteilfehler, nämlich ein Kurzschluss einer Entkoppeldiode 203, 204 im Stromerhöhungspfad eines der beiden digitalen Eingänge I1, I2, zu einem gefährlichen Zustand führen könnte. In Fig. 1 wurde ein Kurzschluss der Entkoppeldiode 203 des zweiten Eingangs I2 mittels einer dort eingezeichneten Brücke F1 grafisch veranschaulicht. Ein gefährlicher Zustand wäre in diesem Fall dann gegeben, wenn am ersten Eingang I1 ein High-Pegel-Signal und am zweiten Eingang I2 ein (hochohmiges) Low-Pegel-Signal (z.B. über einen betätigten Not-Aus-Schalter) anläge. In diesem Fall würde das High-Pegel-Signal am ersten Eingang I1 zu einem Stromfluss über den Stromerhöhungspfad des ersten Eingangs I1 und den Kurzschluss F1 in die Teilschaltung des zweiten digitalen Eingangs I2 führen. Dieses hätte zur Folge, dass das am zweiten digitalen Eingang I2 eigentlich vorhandene Low-Pegel-Signal durch das High-Pegel-Signal am ersten digitalen Eingang I1 gewissermaßen "überschrieben" werden würde. Somit würde die dem zweiten digitalen Eingang I2 zugeordnete Teilschaltung jetzt ebenfalls einen High-Pegel-Zustand erkennen. Das Resultat wäre eine sofortige gefahrbringende Situation, die auch beim Test der Teilschaltungen der beiden digitalen Eingänge I1, I2 mittels der Testeinrichtung 201 nicht erkannt werden könnte. Denn während des Tests würden beide Teilschaltungen der Eingänge I1, I2 ungeachtet des vorhanden Bauteilfehlers der Entkoppeldiode 203 weiterhin einen Low-Pegel-Zustand erkennen, wie es bei einem fehlerfreien Zustand der Teilschaltungen der beiden digitalen Eingänge erwartet wird. Der Bauteilfehler und damit die gefahrbringende Situation blieben somit unentdeckt.

Werden die digitalen Eingänge I1 und I2 der digitalen Eingangsschaltung 200 zum Erfassen eines zweikanaligen Sensorsignals verwendet, so wird durch den nicht erkennbaren Kurzschluss F1 der Entkoppeldiode 203 des zweiten Eingangs I2 die zweikanalige Struktur der Teilschaltungen der beiden digitalen Eingänge I1, I2 aufgehoben. Dieses hätte zur Folge, dass ein zusätzlich auftretender, so genannter "Stuck-at-High-Fehler" (d.h. ein Verharren im High-Pegel-Zustand) am ersten digitalen Eingang I1 ausreicht, um ein Low-Pegel-Signal des Signalgebers am zweiten digitalen Eingang I2 mit dem fehlerhaften High-Pegel-Signal am ersten digitalen Eingang I1 zu "überschreiben". Das bedeutet, dass selbst bei einem zweikanaligen Betrieb bereits zwei Fehler ausreichen, um zu einem gefahrbringenden Zustand zu führen.

In Fig. 2 ist eine digitale Eingangsschaltung 300 mit einer Testeinrichtung 301 gemäß Fig. 3 der DE 10 2013 106 739 A1 gezeigt, wobei in die Stromerhöhungspfade der digitalen Eingänge I1, I2 jeweils eine Entkoppeldiode 303, 304 gemäß Fig. 7 der DE 10 2013 101 932 A1 eingefügt wurde. Die in Fig. 1 und 2 gezeigten digitalen Eingangsschaltungen 200, 300 weisen unterschiedliche Anschaltungen beziehungsweise Anschaltungspunkte der Stromerhöhungseinrichtungen 202, 302 an die jeweiligen Eingangsschaltungen 200, 300 auf. Bei näherer Betrachtung zeigt es sich, dass auch diese Ausführungsform mit erheblichen praktischen Nachteilen verbunden ist.

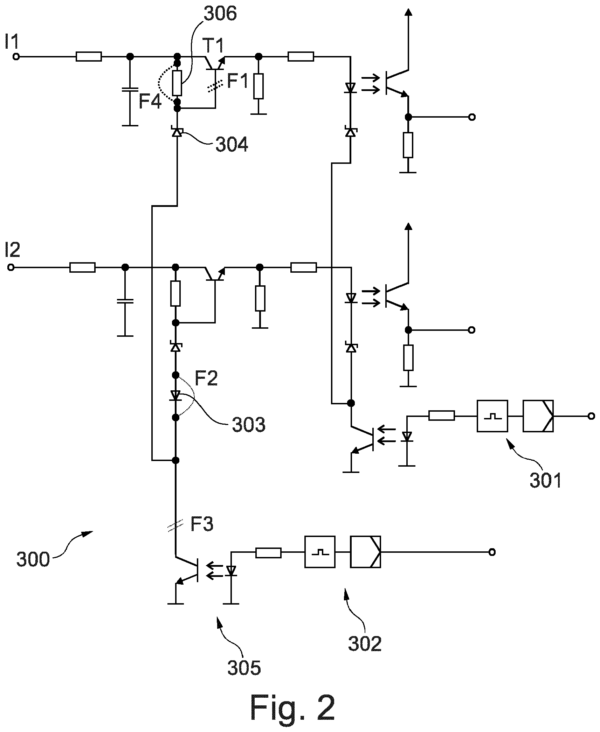

Damit es bei dieser Variante zu einem gefahrbringenden Zustand kommen könnte, müssten je nach Dimensionierung drei oder vier Bauteilfehler vorliegen. Das wären z.B. eine Unterbrechung der Basis eines Transistors T1 der Teilschaltung des ersten digitalen Eingangs I1 (Fehler F1), ein Kurzschluss der Entkoppeldiode 303 der Teilschaltung des zweiten digitalen Eingangs I2 (Fehler F2), eine Unterbrechung eines Kollektors eines Optokopplers 305 der Stromerhöhungseinrichtung 302 (Fehler F3) und je nach Dimensionierung noch ein Kurzschluss eines Widerstands 306 zwischen dem Kollektor und der Basis des Transistors T1 der Teilschaltung des ersten digitalen Eingangs I1 (Fehler F4). Bei diesen Fehlern würde ein High-Pegel-Signal am ersten digitalen Eingang I1 wiederum zu einem Stromfluss über die beiden Stromerhöhungsanschaltungen und den Optokoppler der Teilschaltung des zweiten digitalen Eingangs I2 führen. Wiederum könnte dabei im Fehlerfall ein Low-Pegel-Signal an einem Eingang (vorliegend am zweiten digitalen Eingang I2) durch ein High-Pegel-Signal an einem anderen Eingang (vorliegend am ersten digitalen Eingang 11) "überschrieben" werden. Auch bliebe hier der Nachteil bestehen, dass keiner der Fehler F1 bis F4 durch den Test der Teilschaltungen der beiden digitalen Eingänge I1, I2 erkannt werden könnte. Durch eine Fehlerhäufung könnte es somit auch bei der in Fig. 2 dargestellten digitalen Eingangsschaltung 300 sowohl im einkanaligen als auch im zweikanaligen Betrieb zu einer gefahrbringenden Situation kommen.

Aus der DE 195 10 332 A1 ist eine Eingangsschaltung bekannt, die zwar einen Funktionstest ermöglicht, jedoch keine technischen Maßnahmen für eine Erhöhung des Eingangsstroms bereitstellt.

Eine weitere Eingangsschaltung offenbart die WO 01/48570 A1.

Die vorliegende Erfindung macht es sich somit zur Aufgabe, eine digitale Eingangsschaltung der eingangs genannten Art zur Verfügung zu stellen, die eine Stromerhöhung an den digitalen Eingängen ermöglicht, ein hohes Sicherheitsniveau bei Fehlern, insbesondere bei Bauteilfehlern der Schaltungsarchitektur, erreicht und dabei einfach aufgebaut ist.

Die Lösung dieser Aufgabe liefert eine gattungsgemäße digitale Eingangsschaltung mit den Merkmalen des kennzeichnenden Teils des Anspruchs 1. Die Unteransprüche betreffen vorteilhafte Weiterbildungen der Erfindung.

Eine erfindungsgemäße digitale Eingangsschaltung weist eine kombinierte Test- und Stromerhöhungseinrichtung auf, die dazu ausgebildet ist, ein Ansteuersignal zu erzeugen, derart, dass mit diesem Ansteuersignal gleichzeitig ein Funktionstest der beiden Teilschaltungen durchgeführt wird und ein Eingangsstrom der digitalen Eingänge erhöht wird, wobei jede der beiden Teilschaltungen eine Strombegrenzungseinrichtung mit einem Transistor aufweist und wobei die Teilschaltungen so ausgebildet sind, dass beim Empfangen des Ansteuersignals der kombinierten Test- und Stromerhöhungseinrichtung für den Test der Teilschaltungen die Pegel der digitalen Eingangssignale, die über die digitalen Eingänge den Teilschaltungen zugeführt werden, mittels der Transistoren intern so weit abgesenkt werden, dass sie dem ersten Zustand der betreffenden Teilschaltung entsprechen, und über die Transistoren ein erhöhter Eingangsstrom fließt. Die erfindungsgemäße digitale Eingangsschaltung mit der kombinierten Test- und Stromerhöhungseinrichtung ermöglicht es in vorteilhafter Weise, den Eingangsstrom an den digitalen Eingängen, insbesondere zyklisch, zu erhöhen und dabei gleichzeitig einen Funktionstest der Teilschaltungen der digitalen Eingänge durchzuführen. Durch die erfindungsgemäße Kombination einer Testeinrichtung mit einer Stromerhöhungseinrichtung zu einer einzigen Test- und Stromerhöhungseinrichtung bleibt in vorteilhafter Weise das Sicherheitsniveau der digitalen Eingangsschaltung auch bei Vorliegen von potentiell gefährlichen (Bauteil-)Fehlern auf einem sehr hohen Niveau. Potentiell gefährliche (Bauteil-)Fehler werden durch den während der Stromerhöhungsphasen zeitgleich durchgeführten Test zuverlässig erkannt. Ferner kann in vorteilhafter Weise auf ein potentialtrennendes, ebenfalls potentiell fehlerbehaftetes Bauteil verzichtet werden. Dieses trägt zu einer Vereinfachung des Schaltungsaufbaus und zu einer Verringerung potentieller Fehlerquellen bei. Eine wesentliche Eigenschaft der hier vorgestellten digitalen Eingangsschaltung mit der entsprechend ausgestalteten Test- und Stromerhöhungseinrichtung besteht darin, dass beim Auftreten eines Fehlerstroms, der so hoch ist, dass eine der beiden Teilschaltungen einen High-Pegel-Zustand erkennt, obwohl an dessen Eingang ein Low-Pegel-Signal anliegt, dieser Fehlerstrom auch bei aktivem Test und aktiver Stromerhöhung weiterfließt. Dadurch werden zumindest die potentiell gefährlichen Bauteilfehler durch den Test aufgedeckt. Dadurch, dass die Teilschaltungen erfindungsgemäß so ausgebildet sind, dass beim Empfangen des Ansteuersignals der kombinierten Test- und Stromerhöhungseinrichtung für den Test der Teilschaltungen die Pegel der digitalen Eingangssignale, die über die digitalen Eingänge den Teilschaltungen zugeführt werden, intern so weit abgesenkt werden, dass sie dem ersten Zustand der betreffenden Teilschaltung entsprechen, muss von den Teilschaltungen, die den beiden Eingängen zugeordnet sind, während des Tests jeweils ein Low-Pegel-Zustand, der dem ersten Zustand der betreffenden Teilschaltung entspricht, erkannt werden, auch wenn an den digitalen Eingängen jeweils ein High-Pegel-Signal, welches den zweiten Zustand repräsentiert, anliegt. Wird dieser erste Zustand (Low-Pegel-Zustand) von zumindest einer der Teilschaltungen nicht erkannt, liegt ein Fehler vor. Mittels der vorliegenden Erfindung lassen sich insbesondere auch digitale Eingangsschaltungen des Typs 3 gemäß der Norm IEC61131-2 realisieren.

In einer bevorzugten Ausführungsform wird vorgeschlagen, dass die digitale Eingangsschaltung so ausgebildet ist, dass die Teilschaltungen der digitalen Eingänge nur eine einzige Querverbindung miteinander aufweisen. Dadurch kann die Gefahr, dass sich ein oder mehrere (Bauteil-)Fehler in einer der mindestens zwei Teilschaltungen auf die jeweils andere Teilschaltung auswirken, in vorteilhafter Weise weiter verringert werden. Diese Ausgestaltung wird insbesondere dadurch ermöglicht, dass die digitale Eingangsschaltung erfindungsgemäß die kombinierte Test- und Stromerhöhungseinrichtung und nicht zumindest eine Testeinrichtung und eine hiervon separate Stromerhöhungseinrichtung aufweist.

In einer vorteilhaften Ausführungsform wird vorgeschlagen, dass die erste Teilschaltung ein erstes elektronisches Schaltelement, insbesondere einen ersten Schalttransistor, aufweist, mittels dessen die kombinierte Test- und Stromerhöhungseinrichtung an die erste Teilschaltung angeschlossen ist.

In einer weiteren vorteilhaften Ausführungsform ist vorgesehen, dass die zweite Teilschaltung ein zweites elektronisches Schaltelement, insbesondere einen zweiten Schalttransistor, aufweist, mittels dessen die kombinierte Test- und Stromerhöhungseinrichtung an die zweite Teilschaltung angeschlossen ist.

Die vorzugsweise als Schalttransistoren ausgeführten elektronischen Schaltelemente können mittels des Ansteuersignals der kombinierten Test- und Stromerhöhungseinrichtung angesteuert werden. In einer bevorzugten Ausführungsform können die elektronischen Schaltelemente, insbesondere die Schalttransistoren, der ersten und zweiten Teilschaltung parallel zueinander geschaltet sein.

In einer besonders bevorzugten Ausführungsform kann vorgesehen sein, dass die kombinierte Test- und Stromerhöhungseinrichtung eine Taktreferenzeinrichtung aufweist, die dazu ausgebildet ist, das Ansteuersignal der Test- und Stromerhöhungseinrichtung zu modulieren. Mittels der Taktreferenzeinrichtung wird somit ein moduliertes (getaktetes) Ansteuersignal erzeugt, welches eine Stromerhöhung an den beiden digitalen Eingängen ermöglicht und mittels dessen gleichzeitig die Funktionsfähigkeit der mindestens zwei Teilschaltungen getestet werden kann. Die Taktreferenzeinrichtung kann beispielsweise auf einen Takt eines an den digitalen Eingängen zyklisch auftretenden Störsignals synchronisiert sein.

Gemäß einem weiteren Aspekt betrifft die vorliegende Erfindung eine Sicherheitsschaltvorrichtung zum Ein- und fehlersicheren Ausschalten eines Verbrauchers, insbesondere einer technischen Anlage, wobei die Sicherheitsschaltvorrichtung eine digitale Eingangsschaltung mit mindestens zwei digitalen Eingängen zum Empfangen digitaler Eingangssignale zumindest eines Signalgebers aufweist. Die erfindungsgemäße Sicherheitsschaltvorrichtung zeichnet sich dadurch aus, dass die digitale Eingangsschaltung nach einem der Ansprüche 1 bis 6 ausgeführt ist.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen:
- Fig. 1: ein Beispiel für eine digitale Eingangsschaltung, welche nicht Gegenstand der vorliegenden Erfindung ist,
- Fig. 2: ein weiteres Beispiel für eine digitale Eingangsschaltung, welche nicht Gegenstand der vorliegenden Erfindung ist,
- Fig. 3: eine digitale Eingangsschaltung, die gemäß einem bevorzugten Ausführungsbeispiel der vorliegenden Erfindung ausgeführt ist,
- Fig. 4: eine schematisch stark vereinfacht dargestellte Sicherheitsschaltvorrichtung mit einer digitalen Eingangsschaltung, die gemäß Fig. 3 ausgeführt ist.

Unter Bezugnahme auf Fig. 3 soll nachfolgend ein bevorzugtes Ausführungsbeispiel einer digitalen Eingangsschaltung 100 näher erläutert werden.

Die digitale Eingangsschaltung 100 weist einen ersten Schaltungsabschnitt I auf, der eine Primärseite der digitalen Eingangsschaltung 100 bildet und einen ersten digitalen Eingang 10 und einen zweiten digitalen Eingang 10' umfasst, über die der digitalen Eingangsschaltung 100 binäre Eingangssignale zumindest eines hier nicht explizit dargestellten Signalgebers zugeführt werden können. Der zumindest eine Signalgeber, welcher der digitalen Eingangsschaltung 100 ein digitales Eingangssignal zur Verfügung stellen kann, kann insbesondere eine Sensoreinrichtung oder ein Meldegerät, wie zum Beispiel ein Not-Aus-Taster, ein Not-Halt-Taster, eine Schutztür, eine Schaltmatte, ein Zwei-Hand-Schalter, ein Endlagenschalter oder ein Positionsschalter, sein. Das Meldegerät kann zum Beispiel auch berührungslos arbeiten und zum Beispiel als Lichtgitter oder Lichtschranke ausgeführt sein beziehungsweise diese umfassen.

Die von dem mindestens einen Signalgeber zur Verfügung gestellten digitalen Eingangssignale sind binäre Signale und zeichnen sich durch zwei definierte Zustände aus, die insbesondere durch zwei statische Potentiale gegeben sein können. Wie oben bereits erläutert, sind diese beiden Zustände durch unterschiedliche Spannungspegel gekennzeichnet. Dabei handelt es sich um einen ersten Zustand, in dem die Eingangsspannung U_{IN} einen definierten Schwellwert unterschreitet und der häufig auch als Low-Pegel-Zustand bezeichnet wird, sowie um einen zweiten Zustand, in dem die Eingangsspannung U_{IN} einen definierten Schwellwert überschreitet und der häufig auch als High-Pegel-Zustand bezeichnet wird. Der Low-Pegel-Zustand ist durch eine Eingangsspannung U_{IN} ≤ U_{Low},ₘₐₓ sowie durch einen Eingangsstrom I_{IN} ≤ I_{Low},ₘₐₓ gekennzeichnet. Der High-Pegel-Zustand wird durch eine Eingangsspannung U_{High},ₘᵢₙ ≤ U_{IN} ≤ U_{High,max} und durch einen Eingangsstrom I_{IN} ≥ I_{High},ₘᵢₙ definiert.

Ferner weist die digitale Eingangsschaltung 100 einen zweiten Schaltungsabschnitt II auf, der eine Sekundärseite der digitalen Eingangsschaltung 100 bildet. Drei Koppelelemente 11, 11', 21, auf die weiter unten noch näher eingegangen werden wird, bewirken eine vollständige galvanische Trennung 13 der beiden Schaltungsabschnitte I, II. Diese galvanische Trennung 13 ermöglicht insbesondere einen Schutz der in dem zweiten Schaltungsabschnitt II vorgesehenen elektronischen Bauteile vor Zerstörung durch Überspannungen und daraus resultierenden Fehlern beim Erkennen des AUS-Zustands.

Die digitale Eingangsschaltung 100 umfasst für jeden der beiden digitalen Eingänge 10, 10' jeweils eine Teilschaltung 14, 14'. Einer ersten Teilschaltung 14 wird das digitale Eingangssignal des ersten Eingangs 10 zugeführt und einer zweiten Teilschaltung 14' wird das digitale Eingangssignal des zweiten Eingangs 10' zugeführt. Beide Teilschaltungen 14, 14' weisen in dem hier gezeigten Ausführungsbeispiel einen identischen Schaltungsaufbau auf, der nachfolgend näher erläutert werden soll. Die Teilschaltungen 14, 14' sind in den ersten Schaltungsabschnitt I und in den zweiten Schaltungsabschnitt II unterteilt.

Die beiden Teilschaltungen 14, 14' umfassen jeweils einen Eingangswiderstand 17, 17' sowie zumindest ein Eingangsfiltermittel 12, 12', welches zur Verbesserung der elektromagnetischen Verträglichkeit (kurz: EMV) vorgesehen ist. Generell können die Eingangsfiltermittel 12, 12' ein oder mehrere Bauteile zur Verbesserung der elektromagnetischen Verträglichkeit aufweisen. Bei diesen Bauteilen kann es sich insbesondere um Kondensatoren, Widerstände und Dioden (beispielsweise Z-Dioden) zur Glättung des Eingangssignals beziehungsweise zur Begrenzung einer definierten Eingangsspannung handeln. Die Eingangsfiltermittel 12, 12' der beiden Teilschaltungen 14, 14' wurden vorliegend durch einen Kondensator symbolisiert.

An die Eingangsfiltermittel 12, 12' der beiden Teilschaltungen 14, 14' schließt sich jeweils eine Strombegrenzungseinrichtung 15, 15' an, die in diesem Ausführungsbeispiel als Längsregler ausgebildet ist und einen Transistor 150, 150', der als Bipolartransistor (npn-Transistor) ausgeführt ist, eine Z-Diode 151, 151' sowie einen Vorwiderstand 152, 152' für die Z-Diode 151, 151' umfasst. Die Strombegrenzungseinrichtungen 15, 15' legen einen maximalen Stromfluss in den ihnen zugeordneten digitalen Eingängen 10, 10' fest.

Auf die Strombegrenzungseinrichtung 15 des ersten digitalen Eingangs 10 folgen schließlich ein erstes Koppelelement 11 und ein erstes Schwellwertelement 16. Das erste Koppelelement 11 ist in diesem Ausführungsbeispiel ein Optokoppler mit einer Leuchtdiode 110 auf der Primärseite im ersten Schaltungsabschnitt I und mit einer Kollektor-Emitter-Strecke 111 auf der Sekundärseite im zweiten Schaltungsabschnitt II. Dadurch ist in diesem Schaltungsteil die galvanische Trennung 13 gegeben. Mittels des ersten Koppelelements 11 wird das über den ersten digitalen Eingang 10 zugeführte Eingangssignal zum zweiten Schaltungsabschnitt II übertragen, wobei über das erste Schwellwertelement 16 ein definierter Schwellwert eingestellt wird, den das über den ersten digitalen Eingang 10 zugeführte digitale Eingangssignal überschreiten muss, damit es mit Hilfe des ersten Koppelelements 11 zum zweiten Schaltungsabschnitt II übertragen werden kann. Das erste Koppelelement 11 und das erste Schwellwertelement 16 sind somit dazu in der Lage, den jeweiligen Zustand des Eingangssignals (High-Pegel-Zustand oder Low-Pegel-Zustand) am ersten digitalen Eingang 10 zu detektieren. Sie sind folglich maßgeblich für die Detektion des Low-Pegel-Zustands (AUS-Zustands) zuständig.

Bei dem ersten Schwellwertelement 16 handelt es sich vorliegend um eine Z-Diode, die unmittelbar an der Kathode der Leuchtdiode 110 des Optokopplers angeordnet ist, so dass sich dort ein definierter Spannungspegel als Schwellwert einstellt. Erst wenn das Eingangssignal am ersten digitalen Eingang 10 diesen Spannungspegel überschreitet, fließt ein Strom durch die Leuchtdiode 110 des Optokopplers, so dass die Kollektor-Emitter-Strecke 111 des Optokopplers elektrisch leitend wird. Dadurch kann ein High-Pegel-Signal am ersten digitalen Eingang 10 erfasst werden.

In analoger Weise folgen auf die Strombegrenzungseinrichtung 15' des zweiten digitalen Eingangs 10'ein zweites Koppelelement 11' sowie ein zweites Schwellwertelement 16'. Das zweite Koppelelement 11' ist in diesem Ausführungsbeispiel ebenfalls ein Optokoppler mit einer Leuchtdiode 110' auf der Primärseite im ersten Schaltungsabschnitt I und mit einer Kollektor-Emitter-Strecke 111' auf der Sekundärseite im zweiten Schaltungsabschnitt II. Dadurch ist auch in diesem Schaltungsteil die galvanische Trennung 13 gegeben. Mittels des zweiten Koppelelements 11' wird das über den zweiten digitalen Eingang 10` zugeführte Eingangssignal zum zweiten Schaltungsabschnitt II übertragen, wobei über das zweite Schwellwertelement 16' ebenfalls ein definierter Schwellwert eingestellt wird, welchen das über den zweiten digitalen Eingang 10' zugeführte Eingangssignal überschreiten muss, damit es mit Hilfe des zweiten Koppelelements 11' zum zweiten Schaltungsabschnitt II übertragen werden kann. Das zweite Koppelelement 11' und das zweite Schwellwertelement 16' detektieren somit ihrerseits den jeweiligen Zustand des Eingangssignals am zweiten digitalen Eingang 10' und sind folglich maßgeblich für die Detektion des Low-Pegel-Zustands (AUS-Zustands) zuständig.

Bei dem zweiten Schwellwertelement 16' handelt es sich vorliegend ebenfalls um eine Z-Diode, die unmittelbar an der Kathode der Leuchtdiode 110' des Optokopplers angeordnet ist, so dass sich dort ein definierter Spannungspegel als Schwellwert einstellt. Erst wenn das Eingangssignal am zweiten digitalen Eingang 10' diesen Spannungspegel überschreitet, fließt ein Strom durch die Leuchtdiode 110' des Optokopplers, so dass die Kollektor-Emitter-Strecke 111' des Optokopplers leitend wird.

Über zwei Ausgänge 18, 18', die jeweils an eine der beiden Kollektor-Emitter-Strecken 111, 111' angeschlossen sind, gelangen die digitalen Eingangssignale zu mindestens einer nachgelagerten, hier nicht explizit dargestellten Logikeinheit zur weiteren Signalverarbeitung. Vorzugsweise ist für jeden der beiden Ausgänge 18, 18' eine eigene Logikeinheit vorgesehen. Die Logikeinheiten können zum Beispielaus integrierten Halbleiterbauelementen, insbesondere Mikrocontrollern, ASICs, FPGAs oder anderen integrierten Logikbauelementen aufgebaut sein und vorzugsweise zweikanalig ausgelegt sein, um eine sichere Signalverarbeitung zu gewährleisten. Die Logikeinheiten können Teil der digitalen Eingangsschaltung 100 oder Teil einer Schaltvorrichtung, insbesondere einer Sicherheitsschaltvorrichtung sein, mittels derer ein daran angeschlossener Verbraucher eingeschaltet und sicher ausgeschaltet werden kann. Die Logikeinheiten erzeugen dabei in Anhängigkeit von den Eingangssignalen ein oder mehrere Ausgangssignale zum Ansteuern eines Verbrauchers, insbesondere einer technischen Anlage. Alternativ kann auch nur eine einzige Logikeinheit für beide Ausgänge 18, 18' vorgesehen sein.

Die digitale Eingangsschaltung 100 weist ferner eine kombinierte Test- und Stromerhöhungseinrichtung 20 auf, die in dem hier gezeigten Ausführungsbeispiel teilweise im ersten Schaltungsabschnitt I und teilweise im zweiten Schaltungsabschnitt II realisiert ist. Die kombinierte Test- und Stromerhöhungseinrichtung 20 umfasst das dritte Koppelelement 21, welches eine Kopplung mit dem ersten Schaltungsabschnitt I und somit mit der Primärseite der digitalen Eingangsschaltung 100 bewirkt. Das dritte Koppelelement 21 ist in diesem Ausführungsbeispiel ein Optokoppler mit einer Leuchtdiode 210 im zweiten Schaltungsabschnitt II und mit einer Kollektor-Emitter-Strecke 211 im ersten Schaltungsabschnitt I.

Dadurch ist auch in diesem Schaltungsteil die galvanische Trennung 13 gegeben.

Die Kollektor-Emitter-Strecke 211 des dritten Koppelelements 21 weist einen Anschluss 212 auf, über den das dritte Koppelelement 21, welches Teil der kombinierten Test- und Stromerhöhungseinrichtung 20 ist, an ein erstes elektronisches Schaltelement der Teilschaltung 14 des ersten digitalen Eingangs 10, welches vorliegend als erster Schalttransistor 23 ausgebildet ist, angeschlossen ist. Über den Anschluss 212 ist das dritte Koppelelement 21 darüber hinaus auch an ein zweites elektronisches Schaltelement der Teilschaltung 14' des zweiten digitalen Eingangs 10', welches vorliegend als zweiter Schalttransistor 23' ausgebildet ist, angeschlossen. Die Schalttransistoren 23, 23' der beiden Teilschaltungen 14, 14', die vorliegend als Bipolartransistoren (npn-Transistoren) ausgeführt sind, sind hierbei parallel zueinander geschaltet und nur über eine einzige Querverbindung 213, die auch die einzige Querverbindung zwischen den beiden Teilschaltungen 14, 14' bildet, miteinander verbunden. Die Verbindung mit dem Anschluss 212 des dritten Koppelelements 21 erfolgt über eine gemeinsame Zuleitung 214. Die Basis jedes der beiden Schalttransistoren 23, 23' ist jeweils mit einem Vorwiderstand 19, 19' verbunden.

Die kombinierte Test- und Stromerhöhungseinrichtung 20 ist dazu ausgebildet, ein Ansteuersignal zu erzeugen, wobei mit demselben Ansteuersignal gleichzeitig ein Test der den beiden digitalen Eingängen 10, 10` zugeordneten Teilschaltungen 14, 14' ermöglicht wird und darüber hinaus auch der Eingangsstrom an den digitalen Eingängen 10, 10' erhöht werden kann.

Die kombinierte Test- und Stromerhöhungseinrichtung 20 weist eine Taktreferenzeinrichtung 24 auf, die an das dritte Koppelelement 21 angeschlossen ist, so dass das dritte Koppelelement 21 im Takt der Taktreferenzeinrichtung 24 geschlossen und wieder geöffnet wird und somit elektrisch leitend ist oder nicht. Mittels der Taktreferenzeinrichtung 24 wird somit ein getaktetes, moduliertes Ansteuersignal erzeugt, welches eine Stromerhöhung an den beiden digitalen Eingängen 10, 10' ermöglicht und mittels dessen gleichzeitig die Funktionsfähigkeit der beiden Teilschaltungen 14, 14' getestet werden kann. Das Ansteuersignal steuert jeweils die Basis der Schalttransistoren 23, 23' an.

Für den Test werden dabei die Pegel der digitalen Eingangssignale, die über die digitalen Eingänge 10, 10' eingespeist werden, intern so weit abgesenkt, dass von den Teilschaltungen 14, 14', die den beiden digitalen Eingängen 10, 10' zugeordnet sind, jeweils ein Low-Pegel-Zustand erkannt werden muss, auch wenn an den betreffenden digitalen Eingängen 10, 10' jeweils ein High-Pegel-Signal anliegt.

Wenn die kombinierte Test- und Stromerhöhungseinrichtung 20 aktiviert ist und zyklisch das Ansteuersignal erzeugt, werden die Emitterpotentiale der Transistoren 150, 150' der Strombegrenzungseinrichtungen 15, 15' von den mittels des Ansteuersignals der kombinierten Test- und Stromerhöhungseinrichtung 20 angesteuerten Schalttransistoren 23, 23' auf einen Pegel nahe 0 V (d.h. ein Low-Pegel-Signal, welches dem ersten Zustand entspricht) heruntergezogen. Dadurch wird erreicht, dass der Optokoppler, der das erste Koppelelement 11 bildet, und der Optokoppler, der das zweite Koppelelement 11' bildet, gesperrt sind und die Teilschaltungen 14, 14' der beiden digitalen Eingänge 10, 10' folglich Low-Pegel-Zustände erkennen müssen, sofern sie fehlerfrei arbeiten. Gleichzeitig fließt über die Transistoren 150, 150' der Strombegrenzungseinrichtungen 15, 15' der beiden Teilschaltungen 14, 14' ein erhöhter Eingangsstrom. Dieser wird im Wesentlichen nur durch die Größe des Eingangswiderstands 17, 17' für die jeweiligen Eingänge 10, 10' begrenzt. Wenn nun im aktivierten Zustand der kombinierten Test- und Stromerhöhungseinrichtung 20, in dem das Ansteuersignal in der vorstehend erläuterten Weise erzeugt wird, von einer oder von beiden Teilschaltungen 14, 14' kein Low-Pegel-Zustand erkannt wird, liegt ein Fehler vor.

Die Taktreferenzeinrichtung 24 kann beispielsweise auf einen Takt eines an den digitalen Eingängen 10, 10' zyklisch auftretenden Störsignals synchronisiert sein. Die Stromerhöhung (und folglich auch der Test der beiden Teilschaltungen 14, 14') kann wieder deaktiviert werden, wenn der Störeffekt abgeklungen ist. Das Deaktivieren kann dabei nach einer definierten Schaltdauer des dritten Koppelelements 21, die hier über ein Regelelement 25 eingestellt wird, das an die Taktreferenzeinrichtung 24 angeschlossen ist, oder aktiv, wenn eine übergeordnete Steuer/Auswerteeinheit einer Steuerungseinrichtung, insbesondere einer Sicherheitssteuerungseinrichtung, oder eine Logikeinheit, die Teil der digitalen Eingangsschaltung 100 oder Teil einer Steuerungseinrichtung sein kann, einen definierten Zustand erkannt hat, erfolgen. Das Regelelement 25 zum Einstellen der Schaltdauer kann zum Beispiel auch in die übergeordnete Steuer/Auswerteeinheit oder in eine Logikeinheit integriert sein.

Eine potentielle sicherheitstechnische Gefahr der beiden digitalen Eingänge 10, 10' stellen insbesondere elektrische Querverbindungen zwischen diesen dar. Wenn zwei separate Test- und Stromerhöhungseinrichtungen für zwei (oder auch mehr) digitale Eingänge 10, 10' verwendet werden, resultieren daraus auch mindestens zwei getrennte Querverbindungen zwischen den digitalen Eingängen 10, 10'. Wie weiter oben bereits ausführlich erläutert, kann dieses dazu führen, dass möglicherweise auftretende Bauteilfehler nicht mehr zuverlässig als solche erkannt werden können und es so unter Umständen zu gefährlichen Zuständen kommen kann. Durch die hier vorgesehene kombinierte Test- und Stromerhöhungseinrichtung 20, die beide Funktionen in einer einzigen Baugruppe vereint, gibt es nur noch eine einzige Querverbindung 213 zwischen den Teilschaltungen 14, 14' der beiden digitalen Eingänge 10, 10'. Dabei handelt es sich um diejenigen elektrischen Verbindungsabschnitte, welche den ersten Schalttransistor 23 und den zweiten Schalttransistor 23' miteinander verbinden. Diese einzige Querverbindung 213 ermöglicht in vorteilhafter Weise insbesondere eine rechtzeitige Erkennung von potentiell gefährlichen Bauteilfehlern der digitalen Eingangsschaltung 100, was nachfolgend noch näher erläutert werden soll.

Eine sicherheitstechnische Gefahr geht generell von High-Pegel-Signalen an den digitalen Eingängen 10, 10` und einer Spannungsquelle am vorliegend als Optokoppler ausgebildeten dritten Koppelelement 21 aus. Bei einem Auftreten von Bauteilfehlern könnte es dadurch unter Umständen zu einem Fehlerstrom über die vorhandene Querverbindung 213 zwischen den beiden digitalen Eingängen 10, 10' kommen, wobei dieser Fehlerstrom dazu führt, dass einer der digitalen Eingänge 10, 10' einen High-Pegel-Zustand erkennt, obwohl dort tatsächlich ein Low-Pegel-Signal anliegt.

Nachfolgend sollen die Auswirkungen unterschiedlicher Fehler, die in Fig. 3 mit den Bezugszeichen F1, F2, F3, F4, F5, F6 kenntlich gemacht wurden, auf die digitale Eingangsschaltung 100 näher erläutert werden. Dabei soll davon ausgegangen werden, dass zum Betrachtungszeitpunkt am ersten digitalen Eingang 10 ein High-Pegel-Signal und am zweiten digitalen Eingang 10' ein Low-Pegel-Signal anliegt.

Die Fehler F2 und F4 repräsentieren hierbei fehlerhafte, insbesondere durchtrennte, Masseverbindungen des ersten Schalttransistors 23 und des zweiten Schalttransistors 23'. Bei den übrigen Fehlern F1, F3, F5 und F6 handelt es sich um Kurzschlüsse in den betreffenden elektronischen Bauteilen der ersten beziehungsweise zweiten Teilschaltung 14, 14', die durch entsprechende Brücken symbolisiert wurden.

### Fehler F1 und F2:

Wenn die kombinierte Test- und Stromerhöhungseinrichtung 20 nicht aktiviert ist und somit kein Ansteuersignal zur Stromerhöhung und zum Testen der Teilschaltungen 14, 14' erzeugt, fließt ein Fehlerstrom vom ersten digitalen Eingang 10 über den Transistor 150 der Strombegrenzungseinrichtung 15 und den ersten Schalttransistor 23 der ersten Teilschaltung 14 zum Schalttransistor 23' der zweiten Teilschaltung 14'. Dadurch wird der zweite Schalttransistor 23' eingeschaltet und der Emitter des Transistors 150' der Strombegrenzungseinrichtung 15' der zweiten Teilschaltung 14' wird auf einen Spannungswert von 0 V gezogen, so dass am zweiten digitalen Eingang 10' weiterhin der sichere Low-Pegel-Zustand herrscht, der von der zweiten Teilschaltung 14' entsprechend erkannt werden kann.

Wenn die kombinierte Test- und Stromerhöhungseinrichtung 20 aktiviert ist und somit ein Ansteuersignal zur Stromerhöhung und zum Testen der Teilschaltungen 14, 14' erzeugt, leitet oder sperrt der Optokoppler, der das erste Koppelelement 11 der ersten Teilschaltung 14 bildet, in Abhängigkeit von der Höhe der Eingangsspannung am ersten digitalen Eingang 10. Die Fehlererkennung während des Tests hängt somit von der Höhe der Eingangsspannung am ersten digitalen Eingang 10 ab. Die "sichere" Erkennung der Fehler F1, F2 ist hier jedoch noch nicht erforderlich, da kein gefährlicher Zustand herrscht. Denn der zweite digitale Eingang 10' bleibt in einem sicheren Zustand, da dort trotz der Fehler F1, F2 weiterhin ein (sicherer) Low-Pegel-Zustand vorliegt, der von der zweiten Teilschaltung 14' entsprechend erkannt werden kann.

### Fehler F1, F2, F4 und F5:

Wenn die kombinierte Test- und Stromerhöhungseinrichtung 20 nicht aktiviert ist, fließt ein Fehlerstrom vom ersten digitalen Eingang 10 über den Transistor 150 der Strombegrenzungseinrichtung 15, den ersten Schalttransistor 23 der ersten Teilschaltung 14 und die Basis-Kollektor-Strecke des zweiten Schalttransistors 23', der in der zweiten Teilschaltung 14' vorgesehen ist, in den Optokoppler der zweiten Teilschaltung 14', welcher das zweite Koppelelement 11' bildet. Der Fehlerstrom kann dabei ausreichen, so dass die zweite Teilschaltung 14', welche dem zweiten digitalen Eingang 10' zugeordnet ist, den potentiell gefährlichen High-Pegel-Zustand erkennt.

Wenn die kombinierte Test- und Stromerhöhungseinrichtung 20 aktiviert ist, reicht der Fehlerstrom aus, so dass die zweite Teilschaltung 14', die dem zweiten digitalen Eingang 10' zugeordnet ist, den potentiell gefährlichen High-Pegel-Zustand erkennt. Somit werden diese Fehler beim Test erkannt.

### Fehler F2, F4, F5 und F6:

Wenn die kombinierte Test- und Stromerhöhungseinrichtung 20 nicht aktiviert ist, fließt ein Fehlerstrom von der Spannungsquelle der kombinierten Test- und Stromerhöhungseinrichtung 20 am Optokoppler, der das dritte Koppelelement 21 bildet, über die Basis-Kollektor-Strecke des zweiten Schalttransistors 23' in den Optokoppler der zweiten Teilschaltung 14', welcher das zweite Koppelelement 11' bildet. Dieses hat zur Folge, dass die Teilschaltung 14' des zweiten digitalen Eingangs 10` den potentiell gefährlichen High-Zustand erkennt.

Wenn die kombinierte Test- und Stromerhöhungseinrichtung 20 aktiviert ist, fließt dieser Fehlerstrom auch bei aktivem Test. Die Teilschaltung 14' des zweiten digitalen Eingangs 10' erkennt dabei wiederum den potentiell gefährlichen High-Pegel-Zustand. Somit werden diese Fehler beim Test zuverlässig erkannt. Es soll an dieser Stelle angemerkt werden, dass die Fehler F2 und F4 als so genannte Common-Cause Fehler auch gleichzeitig auftreten können.

Eine wesentliche Eigenschaft der hier vorgestellten kombinierten Test- und Stromerhöhungseinrichtung 20 besteht darin, dass beim Auftreten eines Fehlerstroms, der so hoch ist, dass eine der beiden Teilschaltungen 14, 14' einen High-Pegel-Zustand erkennt, obwohl an dessen Eingang 10, 10' ein Low-Pegel-Signal anliegt, dieser Fehlerstrom auch bei aktivem Test und aktiver Stromerhöhung weiterfließt. Dadurch werden zumindest die potentiell gefährlichen Bauteilfehler durch den Test aufgedeckt. Die fehlerhaften digitalen Eingänge 10, 10' oder ein gesamtes Eingangsmodul, welches diese (und gegebenenfalls noch weitere) digitale Eingänge 10, 10' aufweist, können daraufhin in einen sicheren Zustand versetzt werden und zum Beispiel sicher abgeschaltet werden.

Nachfolgend soll noch kurz der Einfluss der kombinierten Test- und Stromerhöhungseinrichtung 20 auf die Reaktionszeit der digitalen Eingänge 10, 10' erläutert werden. Da bei dieser Realisierung die Teilschaltungen 14, 14' der digitalen Eingänge 10, 10' während der Phasen der Stromerhöhung einen Low-Zustand erkennen, erhöht sich die Reaktionszeit der digitalen Eingänge 10, 10' um die Dauer einer Stromerhöhungsphase. Da die Stromerhöhungsphasen und damit verbunden auch die Testphasen mittels der Taktreferenzeinrichtung 24 jedoch relativ kurz gehalten werden können (z.B. etwa 200 µs), stellt dieses nur einen unwesentlichen Nachteil dar.

Die wesentlichen Vorteile der digitalen Eingangsschaltung 100 mit der kombinierten Test- und Stromerhöhungseinrichtung 20, wie sie hier beschrieben ist, gegenüber separaten Test- und Stromerhöhungseinrichtungen sind insbesondere:
- Aufrechterhalten eines hohen Sicherheitsniveaus der digitalen Eingänge 10, 10' bei verschiedenen Schaltungsarchitekturen, insbesondere auch bei digitalen Eingangsschaltungen 100 mit Stromquellen,
- zuverlässige Erkennung potentiell gefährlicher (Bauteil-)Fehler durch den Test,
- Einsparung eines potentialtrennenden Bauteils.

Es soll an dieser Stelle noch angemerkt werden, dass zusätzliche Testeinrichtungen an den Ausgängen der potentialtrennenden Bauteile, die vorliegend die als Optokoppler ausgebildeten ersten und zweiten Koppelemente 11, 11' zwischen den Schaltungsabschnitten I und II sind, wie sie zum Beispiel in der DE 10 2013 106 739 A1 beschrieben sind, in Fig. 3 nicht dargestellt sind. Für die Realisierung von sicheren Eingängen 10, 10' sind diese Testeinrichtungen gleichwohl erforderlich.

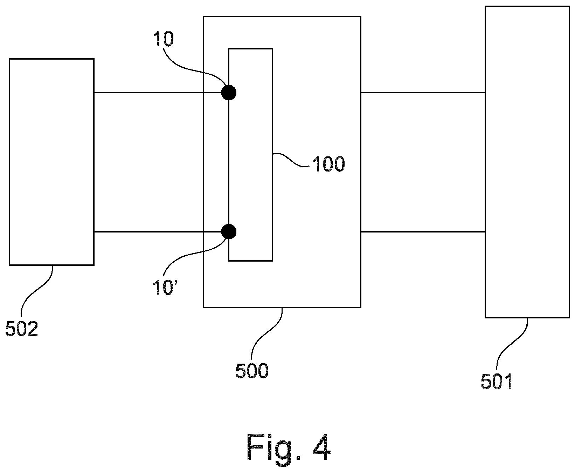

Fig. 4 zeigt in schematisch stark vereinfachter Form eine Sicherheitsschaltvorrichtung 500 zum Ein- und fehlersicheren Ausschalten eines Verbrauchers 501, insbesondere einer technischen Anlage. Die Sicherheitsschaltvorrichtung 500 weist eine digitale Eingangsschaltung 100 mit mindestens zwei digitalen Eingängen 10, 10' zum Empfangen digitaler Eingangssignale eines Signalgebers 502 auf, der insbesondere ein Meldegerät, wie zum Beispiel ein Not-AusSchalter sein kann. Die digitale Eingangsschaltung 100 ist in der oben beschriebenen Weise ausgeführt. Der Signalgeber 502 ist aus Gründen der Redundanz zweikanalig ausgeführt. Die Verbindung zwischen der Sicherheitsschaltvorrichtung 500 und dem Verbraucher 501 ist aus Redundanzgründen ebenfalls zweikanalig gestaltet, so dass zwei Abschaltwege zum sicheren Abschalten des Verbrauchers 501 vorhanden sind.

## Patentansprüche

1. Digitale Eingangsschaltung (100) zum Empfangen digitaler Eingangssignale zumindest eines Signalgebers (502), umfassend
- eine erste Teilschaltung (14) mit einem ersten digitalen Eingang (10), über den der ersten Teilschaltung (14) ein erstes digitales Eingangssignal zuführbar ist, und mit einem ersten Schwellwertelement (16), mittels dessen ein logischer Zustand der ersten Teilschaltung (14) bestimmbar ist, wobei die erste Teilschaltung (14) einen ersten Zustand einnimmt, wenn das erste digitale Eingangssignal einen unteren Schwellwert erreicht oder unterschreitet, und wobei die erste Teilschaltung (14) einen zweiten Zustand einnimmt, wenn das erste digitale Eingangssignal einen oberen Schwellwert erreicht oder überschreitet, sowie
- zumindest eine zweite Teilschaltung (14') mit einem zweiten digitalen Eingang (10'), über den der zweiten Teilschaltung (14') ein zweites digitales Eingangssignal zuführbar ist, und mit einem zweiten Schwellwertelement (16'), mittels dessen ein logischer Zustand der zweiten Teilschaltung (14') bestimmbar ist, wobei die zweite Teilschaltung (14') einen ersten Zustand einnimmt, wenn das zweite digitale Eingangssignal einen unteren Schwellwert erreicht oder unterschreitet, und wobei die zweite Teilschaltung (14') einen zweiten Zustand einnimmt, wenn das zweite digitale Eingangssignal einen oberen Schwellwert erreicht oder überschreitet,
**dadurch gekennzeichnet, dass** die digitale Eingangsschaltung (100) eine kombinierte Test- und Stromerhöhungseinrichtung (20) aufweist, die dazu ausgebildet ist, ein Ansteuersignal zu erzeugen, derart, dass mit diesem Ansteuersignal gleichzeitig ein Funktionstest der beiden Teilschaltungen (14, 14') durchgeführt wird und ein Eingangsstrom der digitalen Eingänge (10, 10') erhöht wird, wobei jede der beiden Teilschaltungen (14, 14') eine Strombegrenzungseinrichtung (15, 15') mit einem Transistor (150, 150') aufweist und wobei die Teilschaltungen (14, 14') so ausgebildet sind, dass beim Empfangen des Ansteuersignals der kombinierten Test- und Stromerhöhungseinrichtung (20) für den Test der Teilschaltungen (14, 14') die Pegel der digitalen Eingangssignale, die über die digitalen Eingänge (10, 10') den Teilschaltungen (14, 14') zugeführt werden, mittels der Transistoren (150, 150') intern so weit abgesenkt werden, dass sie dem ersten Zustand der betreffenden Teilschaltung (14, 14') entsprechen, und über die Transistoren (150, 150') ein erhöhter Eingangsstrom fließt.

2. Digitale Eingangsschaltung (100) nach Anspruch 1, **dadurch gekennzeichnet, dass** die digitale Eingangsschaltung (100) so ausgebildet ist, dass die Teilschaltungen (14, 14') der digitalen Eingänge (10, 10') nur eine einzige Querverbindung (213) miteinander aufweisen.

3. Digitale Eingangsschaltung (100) nach einem der Ansprüche 1 oder 2, **dadurch gekennzeichnet, dass** die erste Teilschaltung (14) ein erstes elektronisches Schaltelement, insbesondere einen ersten Schalttransistor (23), aufweist, mittels dessen die kombinierte Test- und Stromerhöhungseinrichtung (20) an die erste Teilschaltung (14) angeschlossen ist.

4. Digitale Eingangsschaltung (100) nach einem der Ansprüche 1 bis 3, **dadurch gekennzeichnet, dass** die zweite Teilschaltung (14') ein zweites elektronisches Schaltelement, insbesondere einen zweiten Schalttransistor (23'), aufweist, mittels dessen die kombinierte Test- und Stromerhöhungseinrichtung (20) an die zweite Teilschaltung (14') angeschlossen ist.

5. Digitale Eingangsschaltung (100) nach Anspruch 4, **dadurch gekennzeichnet, dass** die elektronischen Schaltelemente, insbesondere die Schalttransistoren (23, 23'), der ersten und zweiten Teilschaltung (14, 14') parallel zueinander geschaltet sind.

6. Digitale Eingangsschaltung (100) nach einem der Ansprüche 1 bis 5, **dadurch gekennzeichnet, dass** die kombinierte Testund Stromerhöhungseinrichtung (20) eine Taktreferenzeinrichtung (24) aufweist, die dazu ausgebildet ist, das Ansteuersignal der Test- und Stromerhöhungseinrichtung (20) zu modulieren.

7. Sicherheitsschaltvorrichtung (500) zum Ein- und fehlersicheren Ausschalten eines Verbrauchers (501), insbesondere einer technischen Anlage, wobei die Sicherheitsschaltvorrichtung (500) eine digitale Eingangsschaltung (100) mit mindestens zwei digitalen Eingängen (10, 10') zum Empfangen digitaler Eingangssignale zumindest eines Signalgebers (502) aufweist, **dadurch gekennzeichnet, dass** die digitale Eingangsschaltung (100) nach einem der Ansprüche 1 bis 6 ausgeführt ist.

## Claims

1. Digital input circuit (100) for receiving digital input signals of at least one signal generator (502), comprising
- a first subcircuit (14) with a first digital input (10), via which a first digital input signal can be supplied to the first subcircuit (14), and with a first threshold value element (16), by means of which a logic state of the first subcircuit (14) can be determined, wherein the first subcircuit (14) adopts a first state, when the first digital input signal reaches or falls below a lower threshold, and wherein the first subcircuit (14) adopts a second state, when the first digital input signal reaches or exceeds an upper threshold, and
- at least one second subcircuit (14') with a second digital input (10'), via which a second digital input signal can be supplied to the second subcircuit (14'), and with a second threshold value element (16'), by means of which a logic state of the second subcircuit (14') can be determined, wherein the second subcircuit (14') adopts a first state, when the second digital input signal reaches or falls below a lower threshold, and wherein the second subcircuit (14') adopts a second state, when the second digital input signal reaches or exceeds an upper threshold,
**characterised in that** the digital input circuit (100) has a combined test and current boosting device (20), which is configured to generate a driving signal such that a function test of the two subcircuits (14, 14') is performed simultaneously with the driving signal and an input current of the digital inputs (10, 10') is increased, wherein each of the two subcircuits (14, 14') has a current limiting device (15, 15') with a transistor (150, 150'), and wherein the subcircuits (14, 14') are configured so that on receiving the driving signal of the combined test and current boosting device (20) for testing the subcircuits (14, 14') the levels of the digital input signals, which are supplied via the digital inputs (10, 10') to the subcircuits (14, 14'), are lowered internally so far by means of the transistors (150, 150') that they correspond to the first state of the relevant subcircuit (14, 14'), and an increased input current flows via the transistors (150, 150').

2. Digital input circuit (100) according to claim 1, **characterised in that** the digital input circuit (100) is configured so that the subcircuits (14, 14') of the digital inputs (10, 10') have only a single cross-connection (213) with one another.

3. Digital input circuit (100) according to any of claims 1 or 2, **characterised in that** the first subcircuit (14) has a first electronic switching element, in particular a first switching transistor (23), by means of which the combined test and current boosting device (20) is connected to the first subcircuit (14).

4. Digital input circuit (100) according to any of claims 1 to 3, **characterised in that** the second subcircuit (14') has a second electronic switching element, in particular a second switching transistor (23'), by means of which the combined test and current boosting device (20) is connected to the second subcircuit (14').

5. Digital input circuit (100) according to claim 4, **characterised in that** the electronic switching elements, in particular the switching transistors (23, 23'), are connected in parallel to the first and second subcircuit (14, 14').

6. Digital input circuit (100) according to any of claims 1 to 5, **characterised in that** the combined test and current boosting device (20) has a clock reference device (24), which is configured to modulate the driving signal of the test and current boosting device (20).

7. Safety switching device (500) for switching on and off a consumer unit (501), in particular a technical installation, in a fail-safe manner, wherein the safety switching device (500) has a digital input circuit (100) with at least two digital inputs (10, 10') for receiving digital input signals of at least one signal generator (502), **characterised in that** the digital input circuit (100) is configured according to any of claims 1 to 6.

## Revendications

1. Circuit d'entrée numérique (100) pour recevoir des signaux d'entrée numériques d'au moins un générateur de signaux (502), comprenant
- un premier circuit partiel (14) avec une première entrée numérique (10), par laquelle un premier signal d'entrée numérique peut être amené au premier circuit partiel (14), et avec un premier élément de valeur seuil (16), au moyen duquel un état logique du premier circuit partiel (14) peut être déterminé, dans lequel le premier circuit partiel (14) adopte un premier état lorsque le premier signal d'entrée numérique atteint ou passe en dessous d'une valeur seuil inférieure, et dans lequel le premier circuit partiel (14) adopte un second état lorsque le premier signal d'entrée numérique atteint ou passe au-dessus d'une valeur seuil supérieure, ainsi que
- au moins un second circuit partiel (14') avec une seconde entrée numérique (10'), par laquelle un second signal d'entrée numérique peut être amené au second circuit partiel (14'), et avec un second élément de valeur seuil (16'), au moyen duquel un état logique du second circuit partiel (14') peut être déterminé, dans lequel le second circuit partiel (14') adopte un premier état lorsque le second signal d'entrée numérique atteint ou passe en dessous d'une valeur seuil inférieure, et dans lequel le second circuit partiel (14') adopte un second état lorsque le second signal d'entrée numérique atteint ou passe au-dessus d'une valeur seuil supérieure,
**caractérisé en ce que** le circuit d'entrée numérique (100) présente un appareil combiné de test et d'augmentation de courant (20) qui est conçu pour générer un signal de commande de telle sorte qu'avec ce signal de commande, un test de fonctionnement des deux sous-circuits (14, 14') est effectué simultanément et un courant d'entrée des entrées numériques (10, 10') est augmenté, dans lequel chacun des deux sous-circuits (14, 14') présente un appareil de limitation de courant (15, 15') avec un transistor (150, 150') et dans lequel les sous-circuits (14, 14') sont conçus de sorte que, lors de la réception du signal de commande de l'appareil combiné de test et d'augmentation du courant (20) pour le test des sous-circuits (14, 14'), les niveaux des signaux d'entrée numériques qui sont transmis par les entrées numériques (10, 10') aux sous-circuits (14, 14') sont abaissés de manière interne au moyen des transistors (150, 150') jusqu'à ce qu'ils correspondent au premier état du circuit partiel (14, 14') concerné et qu'un courant d'entrée accru circule via les transistors (150, 150').

2. Circuit d'entrée numérique (100) selon la revendication 1, **caractérisé en ce que** le circuit d'entrée numérique (100) est conçu de sorte que les sous-circuits (14, 14') des entrées numériques (10, 10') présentent seulement une seule connexion transversale (213) entre eux.

3. Circuit d'entrée numérique (100) selon l'une quelconque des revendications 1 ou 2, **caractérisé en ce que** le premier sous-circuit (14) présente un premier élément de commutation électronique, en particulier un premier transistor de commutation (23), au moyen duquel l'appareil combiné de test et d'augmentation de courant (20) est raccordé au premier sous-circuit (14).

4. Circuit d'entrée numérique (100) selon l'une quelconque des revendications 1 à 3, **caractérisé en ce que** le second sous-circuit (14') présente un second élément de commutation électronique, en particulier un second transistor de commutation (23'), au moyen duquel l'appareil combiné de test et d'augmentation de courant (20) est raccordé au second sous-circuit (14').

5. Circuit d'entrée numérique (100) selon la revendication 4, **caractérisé en ce que** les éléments de commutation électroniques, en particulier les transistors de commutation (23, 23'), du premier et du second sous-circuit (14, 14') sont connectés en parallèle.

6. Circuit d'entrée numérique (100) selon l'une quelconque des revendications 1 à 5, **caractérisé en ce que** l'appareil de test et d'augmentation de courant combiné (20) présente un appareil de référence d'horloge (24) qui est conçu pour moduler le signal d'excitation de l'appareil de test et d'augmentation de courant (20).

7. Dispositif de commutation de sécurité (500) pour la mise en circuit et la mise hors circuit à l'abri des erreurs d'un consommateur (501), en particulier d'une installation technique, dans lequel le dispositif de commutation de sécurité (500) présente un circuit d'entrée numérique (100) avec au moins deux entrées numériques (10, 10') pour la réception de signaux d'entrée numériques d'au moins un générateur de signaux (502), **caractérisé en ce que** le circuit d'entrée numérique (100) est configuré selon l'une quelconque des revendications 1 à 6.
